# EUROPÄISCHE PATENTSCHRIFT

(11) **EP 0 502 381 B1**
(45) Veröffentlichungstag und Bekanntmachung des Hinweises auf die Patenterteilung: **12.10.1994**
(21) Anmeldenummer: 92102942.7
(22) Anmeldetag: 21.02.1992
(51) Int. Cl.: H05K 7/14

(54) **Vorrichtung zum Trennen zweier in Sandwich-Bauweise mittels vielpoliger Steckverbinder miteinander verbundener Leiterplatten**
Device for separating two sandwich-type circuit boards joined together by a multipole connector
Dispositif pour séparer deux plaques conductrices construites en sandwich reliées l'une à l'autre par des connecteurs multipoles accouplés

(30) Priorität: 04.03.1991 DE 9102565 U
(43) Veröffentlichungstag der Anmeldung: 09.09.1992
(73) Patentinhaber: SIEMENS AKTIENGESELLSCHAFT, 80333 München (DE)
(72) Erfinder: Mauch, Richard, W-7500 Eggenstein-Leopoldshafen (DE)

(56) Entgegenhaltungen:
- DE-A- 3 432 102

## Beschreibung

Die Erfindung betrifft eine Vorrichtung zum Trennen zweier in Sandwich-Bauweise mittels vielpoliger Steckverbinder miteinander verbundener Leiterplatten gemäß Oberbegriff des Anspruchs 1.

Insbesondere bei beidseitig bestückten Leiterplatten, die zu zweien oder mehreren parallel in Sandwich-Bauweise angeordnet sind, werden Steckverbindungen benötigt, die aus Platzgründen nicht wie üblich am Rande der Leiterplatten angeordnet werden können, sondern sich in zentralen Bereichen befinden. Das Zusammenfügen der Steckverbindung läßt sich ohne weiteres durch Aufdrücken der oberen Leiterplatte auf eine untere bewerkstelligen. Schwierig wird jedoch das Trennen der Steckverbinder, da gerade bei vielpoligen Steckverbindern eine erhebliche Abzugskraft erforderlich ist, die, läßt man sie auf die Ränder der Leiterplatten wirken, zum Verbiegen derselben und eventuell zum Beschädigen oder Absprengen von Bestückungselementen, insbesondere von solchen in SMD-Technik führen kann.

Es besteht deshalb die Aufgabe, eine Vorrichtung zu schaffen, bei der mit einfachen Mitteln eine Trennung vielpoliger Steckverbindungen zwischen zwei benachbart angeordneten Leiterplatten vorgenommen werden kann.

Eine Lösung der Aufgabe wird in einer Vorrichtung gesehen, die die Merkmale des Anspruchs 1 aufweist. Vorteilhafte Weiterbildungen sind Gegenstände der Unteransprüche.

Mit einfachen mechanischen Mitteln dieser Vorrichtung, nämlich durch Betätigen zweier Schrauben, lassen sich die erheblichen Abzugswiderstände einer vielpoligen Steckverbindung zwischen zwei Leiterplatten überwinden.

Zur Erläuterung der Erfindung ist in den Figuren 1 bis 3 ein Ausführungsbeispiel dargestellt.
- Figur 1: zeigt eine Sandwich-Baugruppe mit zwei Leiterplatten in zusammengestecktem Zustand,
- Figur 2: dieselbe Baugruppe nach Lösung der Steckverbindung und
- Figur 3: die Vorrichtung im einzelnen.

Die schematisch dargestellte Baugruppe besteht aus zwei parallel angeordneten Leiterplatten 1 und 2, die, wie strichpunktiert angedeutet, beidseitig bestückt sind, insbesondere mit Bauelementen in SMD-Technik. Die elektrische Verbindung zwischen den gedruckten Schaltungen der Leiterplatten 1 und 2 wird mittels eines vielpoligen Steckverbinders, z. B. nach DIN 41612, hergestellt, welcher aus zwei Steckerteilen 3 (Messerleiste) und 4 (Federleiste) besteht. Die quaderförmigen Gehäuse der Steckerteile 3 und 4 sind in bekannter Weise an ihren Schmalseiten mit Befestigungsflanschen 5 versehen, die Durchgangslöcher 6 aufweisen.

Das eine Steckerteil 3 ist durch das hier nicht dargestellte Verlöten seiner Anschlußstifte mit dem Leiterbild der Leiterplatte 1 auf dieser befestigt. Die in der Leiterplatte 1 zur Durchführung von Halteschrauben für das Steckerteil 3 vorgesehenen Durchgangsbohrungen 7 sind frei gelassen.

Das andere Steckerteil 4 trägt auf seinen Befestigungsflanschen 5 Abstandsbolzen 8, die mit Innengewinde 9 versehen sind. Sie sind koaxial zu den Durchgangslöchern 6 in den Befestigungsflanschen 5 der Steckerteile 3 und 4 angeordnet, so daß von unten her eine Halteschraube 10 durch die Leiterplatte 2 und den Befestigungsflansch 5 in das Innengewinde 9 des Abstandsbolzens 8 eingeschraubt werden kann, womit das Steckerteil 4 in üblicher Weise befestigt ist.

Vom oberen freien Ende der Abstandsbolzen 8 her ist jeweils eine Schraube 11 bzw. 11′ einschraubbar, deren Schraubenkopf ein Innensechskant 12 als Eingriff für einen Schraubendreher 13 aufweist.

Die Länge L der Abstandsbolzen 8 ist so bemessen, daß sie etwa dem Abstand a zwischen den Befestigungsflanschen 5 der zusammengefügten Steckerteile 3 und 4 abzüglich der Schraubenkopfhöhe h der Schrauben 11, 11′ entspricht. Der Durchmesser des Schraubenkopfs der Schrauben 11, 11′ ist größer als der Durchmesser der Durchgangsbohrungen 7 in der oberen Leiterplatte 1. Die Mantelfläche des Abstandsbolzens 8 kann zylindrisch oder polygon, vorzugsweise sechseckig, sein. Im letzteren Fall läßt sich der Abstandsbolzen mit seinem Fußende in eine serienmäßig vorhandene Vertiefung zur Aufnahme von Sechskantmuttern in den Befestigungsflanschen 5 verdrehsicher einfügen.

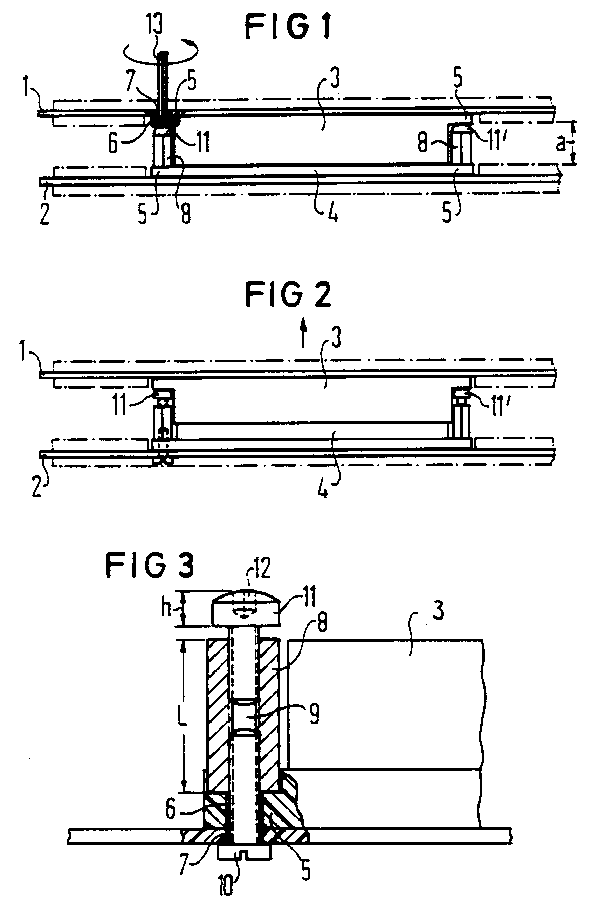

In Figur 1 sind die Steckerteile 3 und 4 zusammengesteckt, die Schrauben 11, 11′ sind voll in die Abstandsbolzen 8 eingedreht.
Um die Steckverbindung zu trennen, wird durch die Bohrung 7 in der Leiterplatte 1 und der koaxial dazu verlaufenden Öffnung 6 im Befestigungsflansch 5 ein Schraubendreher 13 in den Kopf der Schraube 11 eingeführt und dieselbe um etwa fünf bis neun Umdrehungen herausgedreht. Entsprechend wird auf der anderen Seite mit der Schraube 11′ verfahren, bis die Steckverbindung gelöst ist. Dieser Zustand ist in Figur 2 dargestellt. Die obere Leiterplatte 1 läßt sich ohne weiteres abziehen. Daraufhin werden die Schrauben 11 und 11′ wieder voll in die Abstandsbolzen 8 eingedreht, so daß nach Vornahme einer Reparatur oder Umbestückung die Leiterplatte 1 mit ihrem Steckerteil 3 leicht auf das Steckerteil 4 aufgesetzt und durch Zusammendrücken die Verbindung hergestellt werden kann.

## Patentansprüche

1. Vorrichtung zum Trennen zweier in Sandwich-Bauweise mittels vielpoliger Steckverbinder miteinander verbundener, bestückter Leiterplatten, wobei die quaderförmigen Steckerteile mit an den Schmalseiten angeordneten Befestigungsflanschen mit Durchgangslöchern in Steckrichtung senkrecht zur Ebene der jeweiligen Leiterplatte auf dieser angebracht sind, **dadurch gekennzeichnet**, daß das eine Steckerteil (3) durch Verlötung seiner Anschlußstifte mit dem Leiterbild auf der ersten Leiterplatte (1) befestigt ist und in dieser Durchgangsbohrungen (7) koaxial zu den Durchgangslöchern (6) in den Befestigungsflanschen (5) angebracht sind,
und daß auf den Befestigungsflanschen (5) des anderen Steckerteils (4) koaxial zu den Durchgangslöchern (6) Abstandsbolzen (8) mit Innengewinde (9) angeordnet sind, in welche von unten her Halteschrauben (10) zur Befestigung des Steckerteils (4) auf der anderen Leiterplatte (2) und von dem oberen freien Ende her Schrauben (11, 11′) eindrehbar sind, deren Kopfdurchmesser größer ist als der Durchmesser der Durchgangslöcher (6) in den Befestigungsflanschen (5), wobei die Länge (L) der Abstandsbolzen (8) etwa dem Abstand a der Befestigungsflansche (5) der beiden zusammengesteckten Steckerteile (3 und 4) abzüglich der Schraubenkopfhöhe (h) der oberen Schrauben (11) entspricht.

2. Vorrichtung nach Anspruch 1, **dadurch gekennzeichnet**, daß die Mantelflächen der Abstandsbolzen (8) zylindrisch oder polygon sind.

3. Vorrichtung nach Anspruch 1, **dadurch gekennzeichnet**, daß die Schraubenköpfe der oberen Schrauben (11) mit Innensechskant- oder ähnlichen Eingriffen (12) für Schraubendreher (13) versehen sind.

## Claims

1. A device for separating two circuit boards fitted with components and joined together in a sandwich by multipole connectors, the narrow sides of the square plug parts being formed with securing flanges with holes in the plug-in direction at right angles to the plane of the respective circuit board to which they are secured, characterised in that the connecting pins of one plug part (3) are welded to the conductors on the first circuit board (1), which is formed with bores (7) coaxial with the holes (6) in the securing flanges (5), and
spacer bolts (8) coaxial with the holes (6) are disposed on the securing flanges (5) of the other plug part (4) and have an inner thread (9) for screwing in retaining screws (10) from underneath for securing the plug part (4) to the other circuit board (2) and screws (11, 11′) from the free top end, the diameter of the screw heads being greater than the diameter of the holes (6) in the securing flanges (5), the length (L) of the spacer bolts (8) being about equal to the spacing a between the securing flanges (5) of the two plug parts (3 and 4) when fitted together, minus the head height (h) of the upper screws (11).

2. A device according to claim 1, characterised in that the surfaces of the spacer bolts (8) are cylindrical or polygonal.

3. A device according to claim 1, characterised in that the heads of the upper screws (11) are formed with inner hexagons or similar regions (12) for engagement by screwdrivers (13).

## Revendications

1. Dispositif pour séparer deux plaquettes à circuits imprimés équipées, reliées entre elles selon une structure sandwich au moyen de connecteurs multipolaires, les éléments de connecteur parallélépipédiques étant disposés sur la plaquette à circuits imprimés respective au moyen de brides de fixation situées sur les petits côtés et comportant des trous de passage s'étendant dans la direction d'enfichage perpendiculairement au plan de la plaquette à circuits imprimés respective, caractérisé par le fait qu'un élément de connecteur (3) est fixé par brasage de ses broches de raccordement sur la configuration conductrice située sur la première plaquette à circuits imprimés (1) et que dans cette plaquette, des perçages traversants (7) sont disposés coaxialement aux trous de passage (6) ménagés dans les brides de fixation (5), et
que sur les brides de fixation (5) de l'autre élément de connecteur (4) sont disposées, coaxialement aux trous de passage (6), des boulons-entretoises (8) possédant un taraudage (9) et dans lesquels peuvent être vissées, à partir du bas, des vis de fixation (10) servant à fixer l'élément de connecteur (4) à l'autre plaquette à circuits imprimés (2) et, à partir de l'extrémité libre supérieure, des vis (11, 11′), dont le diamètre des têtes est supérieur au diamètre des trous de passage (6) ménagés dans les brides de fixation (5), la longueur (L) des boulons-entretoises (8) correspondant approximativement à la distance a entre les brides (5) de fixation des deux éléments de connecteur (3 et 4) réunis par enfichage, déduction faite de la hauteur (h) de la tête des vis supérieures (11).

2. Dispositif suivant la revendication 1, caractérisé par le fait que les surfaces enveloppes des boulons-entretoises (8) sont cylindriques ou polygonales.

3. Dispositif suivant la revendication 1, caractérisé par le fait que les têtes des vis supérieures (11) comportent des cavités d'engrènement (12) du type à six pans creux ou semblables, pour l'engagement d'un tournevis (13).
